# EUROPÄISCHE PATENTSCHRIFT

(11) **EP 3 695 298 B1**
(45) Veröffentlichungstag und Bekanntmachung des Hinweises auf die Patenterteilung: **08.09.2021**
(21) Anmeldenummer: 19722116.1
(22) Anmeldetag: 06.05.2019
(51) Int. Cl.: G06F 3/0362, G06F 3/039

(54) **EINGABEVORRICHTUNG MIT BEWEGLICHER HANDHABE AUF KAPAZITIVER DETEKTIONSFLÄCHE UND KAPAZITIVEN KOPPELEINRICHTUNGEN**
INPUT ASSEMBLY WITH MOVEABLE HANDLE ON A CAPACITIVE DETECTION PLANE AND CAPACITIVE COUPLING ELEMENTS
DISPOSITF D'ENTRÉE AYANT UN MANIPULATEUR MOBILE SUR UNE SURFACE DE DÉTECTION CAPACITIVE ET DES MOYENS DE COUPLAGE CAPACITIFS

(30) Priorität: 12.07.2018 DE 102018116876; 23.08.2018 DE 102018120575
(43) Veröffentlichungstag der Anmeldung: 19.08.2020
(73) Patentinhaber: Preh GmbH, 97616 Bad Neustadt a.d. Saale (DE)
(72) Erfinder: MARTIN, Michael, 97618 Unsleben (DE); SCHMIDT, Benedikt, 97650 Fladungen (DE); KLEIN, Markus, 97616 Salz (DE)
(74) Vertreter: Lohmanns, Bernard
(86) Internationale Anmeldenummer: PCT/EP2019/061534
(87) Internationale Veröffentlichungsnummer: WO 2020/011416

(56) Entgegenhaltungen:
- EP-A1- 2 187 290
- WO-A2-2017/072232
- DE-A1-102007 024 874
- DE-A1-102014 218 493
- US-A1- 2014 042 004

## Beschreibung

Die Erfindung betrifft eine Eingabevorrichtung gemäss dem unabhängigen Anspruch 1. Eine derartige, aus Kombination eines Touchpads oder Touchscreens mit einer darauf beweglich angeordneten Handhabe gebildeten Eingabevorrichtung wird zunehmend beliebter, da dadurch flexible Eingabemöglichkeiten geschaffen werden und insbesondere bei einem Touchscreen aufgrund der flexiblen Anzeigemöglichkeiten der Handhabe vielfältige Funktionen und Funktionshinweise zugeordnet werden können. Andererseits stellt aber die Handhabe ein gewohntes haptisches Feedback bereit und kann leicht vom Benutzer ohne Sichtkontakt ertastet werden. Aufgrund der gewünschten Nutzung des unter der Handhabe befindlichen und von der Handhabe überdeckten Bereichs der kapazitiven Elektrodenstruktur zur Stellungsdetektion ist eine kapazitive Kopplung zwischen der Handhabe, insbesondere der dort vorgesehenen Koppelelektrode und dem kapazitiven Touchscreen beziehungsweise kapazitiven Touchpad erforderlich.

Diese kapazitive Beeinflussung ist im Allgemeines nur schwer von einer kapazitiven Beeinflussung durch äußere Störeinflüsse durch wasserhaltige Flüssigkeiten zu unterscheiden.

Es hat sich gezeigt, dass die kapazitive Beeinflussung zwischen Koppelelektrode und Arrayelektrode nicht zuverlässig von Störeinflüssen unterscheiden werden kann und somit die Stellungsdetektion der Handhabe unzuverlässig ist.

Die DE10 2014 218493 offenbart einen Drehsteller (Bedienelement 3; dieser ist drehbar, und auch translatorisch in einem gewissen Rahmen verschiebbar) mit einem inneren Ring (8"') als rotierbares Element (gegenüber den beiden anderen Ringen 8' und 8") welches inter alia kapazitive Markierungen aufweist. Der Drehstelller ist an einem Touchscreen angebracht.

Die US 2014/042004 offenbart ebenfalls einen Drehknopf welcher an seinem Boden ein fest angebrachtes Muster von Elektroden hat (first pads 111). Er weist ein drehbares Element (turning knob 120) auf innerhalb dessen weitere Elektroden (third pads 122) auf zwei konzentrischen Kreisen angebracht sind. Das drehbares Element (turning knob 120) wird in eine kreisrunde Öffnung einer Basis (base 110) eingesetzt. In dieser kreisrunden Öffnung sind auf ebenfalls konzentrischen Kreisen weitere Elektroden (second pads 112) angebracht. Eine Drehung des drehbaren Elementes (turning knob 120) bewirkt einen Kontakt der "third pads (122)" mit den "second pads 112". Je nach Drehrichtung werden die Elektroden auf einen der beiden konzentrischen Kreise zuerst geschlossen. Diese zeitliche Abfolge wird detektiert um daraus die Drehrichtung (nicht die Stellung) zu bestimmen.

Vor diesem Hintergrund bestand Bedarf nach einer gattungsgemäßen Eingabevorrichtung, bei der eine verbesserte, gezielte kapazitive Kopplung zwischen der kapazitiven Detektionseinrichtung, beispielsweise dem kapazitiven Touchscreen, und der Handhabe, insbesondere mit der and der Handhabe vorgesehenen Koppelelektrode erreicht wird. Diese Aufgabe wird durch eine Eingabevorrichtung gemäß Anspruch 1 gelöst. Eine gleichermaßen vorteilhafte Verwendung ist Gegenstand des nebengeordneten Anspruchs. Vorteilhafte Ausgestaltungen sind jeweils Gegenstand der abhängigen Ansprüche. Es ist darauf hinzuweisen, dass die in den Ansprüchen einzeln aufgeführten Merkmale in beliebiger, technologisch sinnvoller Weise miteinander kombiniert werden können und weitere Ausgestaltungen der Erfindung aufzeigen. Die Beschreibung, insbesondere im Zusammenhang mit den Figuren, charakterisiert und spezifiziert die Erfindung zusätzlich.

Die Erfindung betrifft eine Eingabevorrichtung, welche eine kapazitive Detektionseinrichtung beinhaltet und dabei die Detektionseinrichtung eine Detektionsfläche unter Ausbildung eines der Detektionsfläche zugeordneten Arrays von Arrayelektroden aufweist. Die Arrayelektroden, auch kurz als Elektroden bezeichnet, sind beispielsweise in einer gemeinsamen Ebene oder auf zwei oder mehr parallelen Ebenen angeordnet. Die Anordnung und Lage der Arrayelektroden wird bevorzugt durch eine regelmäßige, noch bevorzugter rechtwinklige, gedachte Gitterstruktur, auch kurz Gitter genannt, beschrieben ist, wobei die Lage der durch die Arrayelektroden zu erzeugenden Messfelder durch die Knotenpunkte definiert ist. Dabei ist ein Knotenpunkt beispielsweise durch einen Kreuzungspunkt von zwei Arrayelektroden definiert. Der Begriff Elektrode soll die Ausbildung der betroffenen Elektrode aus leitfähigen Material, beispielsweise aus Metall oder einer metallischen Legierung implizieren. Bei der Detektionseinrichtung handelt es sich beispielsweise um ein kapazitives Touchpad oder einen kapazitiven Touchscreen. Erfindungsgemäß ist ferner eine elektrisch mit den Arrayelektroden verbundene, bevorzugt elektrisch leitend verbundene, elektronische Auswerteinheit vorgesehen, um mittels des Arrays von Arrayelektroden ein zugehöriges, bevorzugt in zeitlicher Abfolge erzeugtes und zeitlich variierendes, Array von elektrischen Messfeldern zur ortsauflösenden Detektion einer kapazitiven Beeinflussung auf der Detektionsfläche auszubilden. Beispielweise handelt es sich um eine kapazitive Detektionseinrichtung in projiziert-kapazitiver Technologie, insbesondere um eine solche mutual-capacitance Aufbau. Bei dem mutual-capacitance Aufbau werden Messfelder und somit Messkapazitäten an den Knotenpunkten zwischen zwei elektrisch isolierten, sich kreuzenden Elektrodenstrukturen erzeugt. Die Knotenpunkte sind bei handelsüblichen Touchpads oder Touchscreens in einem rechtwinkligen Gitter angeordnet.

Die Auswerteinheit ist in der Lage, die mehreren Messkapazitäten und deren Beeinflussung zu messen. Wenn das jeweilige Messfeld durch eine äußere Annäherung eines Objekts beeinflusst wird, wird die durch die Auswerteinheit gemessene elektrische Messkapazität, beispielsweise am betreffenden Knotenpunkt, verändert und detektiert und kann aufgrund der Elektrodenstruktur, bevorzugt nach Reihen und Spalten gegliederten Elektrodenstruktur, einem Ort auf der Detektionsfläche zugeordnet werden.

Die Eingabevorrichtung weist erfindungsgemäß eine Handhabe auf, die beweglich entlang eines Stellwegs unter Breitstellung eines ersten Bewegungsfreiheitsgrades auf der Detektionsfläche mittels Lagermittel angeordnet ist, bevorzugt über die Lagermittel befestigt ist, um eine Bedieneingabe bei Bewegung, insbesondere unter Berührung der Handhabe durch einen Bediener, vorzunehmen. Beispielsweise handelt es sich um eine entlang eines linearen Stellwegs in einer zur Detektionsfläche parallelen Richtung translatorisch bewegbar gelagerte Handhabe. Bevorzugt ist die Handhabe um eine zur Detektionsfläche orthogonale Drehachse drehbeweglich an der Detektionsfläche gelagert und qualifiziert die Eingabevorrichtung damit als einen Drehsteller.

Erfindungsgemäß ist ferner eine Koppelelektrode vorgesehen, die mit der Handhabe mitbewegt wird. Es handelt sich dabei um eine Elektrode, was wie zuvor erwähnt die Verwendung eines leitfähigen Materials impliziert. Der Begriff "Koppelelektrode" soll ferner eine kapazitive Kopplung zu wenigstens einem der Messfelder implizieren. Die Koppelelektrode ist beispielsweise gegenüber der Auswerteinheit elektrisch isoliert ausgebildet. Sie kann ein oder mehrteilig ausgebildet sein, wobei die mehreren Teile bevorzugt elektrisch leitend verbunden sind. In einer anderen Ausgestaltung ist sie mit dem Bediener elektrisch leitend oder kapazitiv gekoppelt ausgebildet und angeordnet. Es sind ferner mehrere, entlang des Stellwegs verteilt auf der Detektionsfläche angeordnete, jeweils elektrisch isolierte Koppeleinrichtungen aus leitfähigem Material, vorgesehen. Die Koppeleinrichtungen sind jeweils so angeordnet und ausgebildet, dass nicht nur genau eines, sondern jeweils mehrere benachbarte Messfelder mit einer zugehörigen Koppeleinrichtung der mehreren Koppeleinrichtungen kapazitiv koppeln, wobei die zu einer Koppeleinrichtung zugeordneten Messfelder jeweils genau einen, bevorzugt zusammenhängenden, Teilbereich der Detektionsfläche definieren. Beispielsweise wird dies dadurch erreicht, dass eine der Detektionsfläche zugewandte Einkoppelfläche der Koppeleinrichtung eine Abmessung aufweist, die in ihren zwei orthogonalen Richtungen größer, bevorzugt mehrfach größer als der mittlere Arrayelektrodenabstand, beispielsweise der mittlere Abstand der Knotenpunkte ist.

Erfindungsgemäß sind mehrere Stellungen der Handhabe entlang deren Stellwegs vorgesehen, bei der die Koppelelektrode stellungsabhängig zu wenigstens einer der Koppeleinrichtungen nächstbenachbart angeordnet ist, um eine weitere kapazitive Kopplung zwischen genau diesen stellungsabhängig spezifischen Koppeleinrichtungen und der Koppelelektrode auszubilden oder diese stellungsabhängig elektrisch zu kontaktieren. Anders ausgedrückt ist für mehrere unterschiedliche Stellungen der Handhabe entlang des Stellwegs jeweils eine oder mehrere spezifische Koppeleinrichtung aus der Vielzahl von Koppeleinrichtungen nächstbenachbart zu der Koppelelektrode angeordnet, damit diese stellungsabhängig eine kapazitive Kopplung mit der jeweiligen Koppeleinrichtung ausbilden oder diese elektrisch kontaktieren.

Die Gesamtheit der zu einer jeweiligen Koppeleinrichtung gehörigen Messfelder definiert einen, bevorzugt zusammenhängenden, Teilbereich der Detektionsfläche. Erfindungsgemäß ist die elektronische Auswerteinheit ausgebildet, die durch die e kapazitive Kopplung bewirkte stellungsabhängige Beeinflussung der Messfelder zu detektieren, um eine Stellungsinformation der Handhabe zu erhalten und auszugeben. Anders ausgedrückt, die Auswerteinheit ist in der Lage anhand die von der Stellung der Handhabe und damit der Koppelelektrode bewirkte Beeinflussung der betreffenden Messfelder zu identifizieren und somit der Beeinflussung eine Stellungsinformation zuzuordnen und diese beispielsweise zur Vornahme einer Steuer- oder Schaltfunktion an eine übergeordnete Steuereinrichtung auszugeben.

Eine kapazitive Kopplung zwischen der Koppelelektrode und einem Messfeld ist dann erreicht, wenn die sich aus der Kopplung ergebende Beeinflussung mittels der elektronischen Auswerteinheit zuverlässig detektiert werden kann. Um kapazitive Kopplung sicher aus dem Signal extrahieren zu können, muss sich das Nutzsignal deutlich vom Hintergrundrauschen abheben. Beispielsweise muss das Signal-Rausch-Verhältnis also ausreichend groß sein.

Erfindungsgemäß wird dies dadurch erreicht, dass die Kopplung zwischen Koppeleinrichtung und Arrayelektroden nicht nur mit einem Messfeld, sondern mehreren Messfeldern und damit mit von einer Vielzahl von Arrayelektroden hervorgerufenen Messfeldern erreicht wird. Durch die erfindungsgemäße Lösung wird erreicht, dass eine mehrfache Beeinflussung von Messfeldern durch die Koppelelektrode für jede Koppeleinrichtung erreicht wird. Ferner kann durch die kapazitive Kopplung zu mehreren unterschiedlichen Knotenpunkten die Genauigkeit der Stellungsdetektion gesteigert und robust gegen äußere Störeinflüsse durch wasserhaltige Flüssigkeiten gemacht werden. Ferner kann der von der kapazitiven Kopplung zu überbrückende Abstand zwischen Koppelelektrode und Arrayelektrode durch die erfindungsgemäß vorgesehenen Koppeleinrichtungen minimiert werden. Beispielsweise können die für eine bestimmte Stellung und/oder Bewegung charakteristischen kapazitiven Beeinflussungen durch Simulation oder Kalibrierung bestimmt werden und als Daten in einem Speichermedium hinterlegt werden. Während des Auswertvorgangs kann dann die Auswerteinheit auf diese Daten zugreifen und diese zur Auswertung der aktuellen Stellung und/oder Bewegung benutzen, beispielsweise unter Verwendung eines Korrelationsalgorithmus oder dergleichen. Beispielsweise werden die detektierten kapazitiven Beeinflussungen von der Auswerteinheit als Daten für eine analytische Auswertung, die beispielsweise die Verwendung von ein- oder mehrdimensionalen Gauss-Funktionen oder dergleichen beinhaltet, benutzt. Beispielsweise werden die detektierten kapazitiven Beeinflussungen von der Auswerteinheit als Daten für eine statistische Auswertung benutzt.

Gemäß einer bevorzugten Ausgestaltung ist die Handhabe zur Breitstellung eines zweiten Bewegungsfreiheitsgrades in Bezug zur Detektionsfläche rückstellend aus einer Ruhestellung in eine Endstellung bewegbar gelagert, beispielsweise bezüglich einer zur Detektionsfläche orthogonalen gedachten Achse verkippbar oder im Wesentlichen orthogonal zur Detektionsfläche verschiebbar oder parallel zur Detektionsfläche verschiebbar gelagert. Dabei ist die Endstellung jeweils so gewählt ist, dass es in der Endstellung durch die kapazitive Kopplung oder elektrische Kontaktierung zur kapazitiven Beeinflussung mehrerer, mehreren Teilbereichen zugeordneten Messfeldern kommt, die insgesamt einen, bevorzugt zusammenhängenden, Multibereich der Detektionsfläche definieren. Dabei ist die elektronische Auswerteinheit ausgebildet, die durch die kapazitive Kopplung bzw. elektrische Kontaktierung bewirkte kapazitive Beeinflussung der zum Multibereich gehörigen Messfelder zu detektieren, um ferner eine Verlagerungsinformation der Handhabe zu erhalten und auszugeben.

Durch die kapazitive Beeinflussung mehrerer Messfelder mittels mehrerer Koppeleinrichtungen ist zuverlässig und einfach eine zusätzliche Funktionalität wie eine sogenannte Push-Funktionalität realisiert. Beispielsweise wird in der zugehörigen Endstellung der Verschiebung oder Verkippung ein Berührkontakt zwischen der Koppelelektrode und mehreren, beispielsweise stellungsabhängig zugehörigen, oder allen Koppeleinrichtungen hergestellt, um die in die Endstellung verlagerte Stellung der Handhabe zuverlässig zu detektieren.

Beispielsweise liegen die zu einer Endstellung und damit zu einem Multibereich zugehörigen Koppeleinrichtungen nächstbenachbart zueinander.

Gemäß einer noch bevorzugteren Ausgestaltung ist die die Handhabe in Bezug zur Detektionsfläche in mehrere unterschiedliche, richtungsspezifische Endstellungen verlagerbar gelagert, und pro richtungsspezifischer Endstellungen ist jeweils ein richtungsspezifischer Multibereich vorgesehen. Dabei ist die elektronische Auswerteinheit ausgebildet, die durch die erste und zweite kapazitive Kopplung bewirkte kapazitive Beeinflussung der zu den richtungsspezifischen Multibereichen gehörigen Messfelder zu detektieren, um eine richtungsspezifische Verlagerungsinformation der Handhabe zu erhalten und auszugeben. Beispielsweise sind dem Multibereich für eine Verkippung der Handhabe in Richtung "rechts" andere Koppeleinrichtungen zugeordnet als der Verkippung der Handhabe in Richtung "links". Damit ist zuverlässig und einfach eine sogenannte "Joystick"- oder "Wipptasten"-Funktionalität realisiert.

Beispielsweise besteht die Koppelelektrode zumindest teilweise aus einem Stanzbiegeteil aus Metallblech und ist form- oder kraftschlüssig mit der Handhabe verbunden. Beispielsweise besteht das Koppelelektrode zumindest teilweise aus einem Kugellager, dessen Innenring oder Außenring an der Handhabe befestigt ist, wobei der Innen- oder Außenring in einer Endstellung in kapazitivem oder elektrisch leitendem Kontakt mit mehreren Koppeleinrichtungen ist. Bevorzugt besteht das Koppelelektrode aus einem Stanzbiegeteil aus Metallblech und einem damit kapazitiv oder elektrisch verbundenen Kugellager.

Bevorzugt erstrecken sich die Teilbereiche und/oder ein Multibereich über einen sich beidseitig des vom Anordnungsverlauf der Koppeleinrichtungen beschriebenen Stellwegs. Auf diese Weise kann die Auswerteinheit den Störeinfluss eines Wassertropfens, welcher sich beispielsweise nur auf einer Seite des Stellwegs und damit nur teilweise in einem Teilbereich oder einem Multibereich befindet, leichter feststellen.

Bevorzugt beträgt der Abstand in der jeweiligen Stellung zwischen zur Stellung zugehöriger Koppeleinrichtung, weil es sich zur in der betreffenden Stellung um die zur Koppelelektrode nächstbenachbarte Koppeleinrichtung handelt, und der Koppelelektrode jeweils weniger als 1 mm, bevorzugter weniger als 0,5 mm und meist bevorzugt weniger als 0,1 mm.

Gemäß einer bevorzugten Ausgestaltung sind die mehreren Koppeleinrichtungen an den Lagermitteln befestigt. Bevorzugt sind die mehreren Koppeleinrichtungen form-, kraft- und/oder stoffschlüssig mit den Lagermitteln verbunden, beispielsweise sind die Koppeleinrichtungen durch Umformen in einem formgebenden Verfahren, beispielsweise Umspritzen, an den Lagermitteln befestigt. Beispielsweise wird eine einstückige Verbindung zwischen Koppeleinrichtungen und Lagermitteln durch deren Herstellung in einem 2K-Spritzformverfahren oder durch partielles Galvanisieren eines Kunststoffs realisiert.

Bevorzugt ist die Handhabe um eine zur Detektionsfläche orthogonale Drehachse drehbeweglich an der Detektionsfläche gelagert und qualifiziert diese damit als Drehsteller. Der von der Anordnung der Koppeleinrichtungen beschriebene Stellweg umschließt somit einen im Wesentlichen kreisrunden Innenbereich der Detektionsfläche.

Gemäß einer bevorzugten Ausgestaltung gibt es im Innenbereich mindestens ein Messfeld und damit wenigstens eine Arrayelektrode die keinem stellungsabhängig möglichen Teilbereiche und keinem Multibereich zugeordnet ist Auf diese Weise kann bei entsprechender Ausgestaltung des Drehstellers, beispielsweise als Drehring, der Innenbereich der Detektionsfläche zur Detektion weiterer Funktionalitäten der Eingabevorrichtung, wie beispielsweise eine Erkennung einer Berührung durch den Benutzer oder dergleichen, genutzt werden.

Bevorzugt sind die mehreren Koppeleinrichtungen um die Drehachse verteilt, beispielsweise in Umfangsrichtung gleichmäßig verteilt, angeordnet.

Gemäß einer bevorzugten Variante bilden die Lagermittel einen Ring aus Kunststoff, beispielsweise aus einem Thermoplast, aus und die mehreren Koppeleinrichtungen sind in dem Ring aus Kunststoff aufgenommen. Beispielsweise weist der Ring eine Stirnfläche auf, die eine Anlagefläche zur Anordnung auf der Detektionsfläche darstellt.

Neben der Lagerung des Drehstellers und der Aufnahme der mehreren Koppeleinrichtungen dient der Kunststoffring dazu, den Innenbereich der Detektionsfläche vom restlichen Teil der Detektionsfläche, dem Außenbereich, zumindest teilweise physikalisch zu trennen. Beispielsweise hält der Kunststoffring einen Wassertropfen davon ab vom einem Außenbereich in den Innenbereich einzudringen und umgekehrt. Auf diese Weise kann die Auswerteinheit den Störeinfluss eines Wassertropfens, welcher sich dann beispielsweise nur auf Außenseite der Detektionsfläche und damit nur teilweise in einem Teilbereich oder einem Multibereich befindet, leichter feststellen.

Beispielsweise sind die Koppeleinrichtungen stabförmig ausgebildet. Beispielsweise weist die Koppeleinrichtung jeweils eine zur Detektionsfläche orthogonale Haupterstreckungsrichtung auf. In einer Ausgestaltung ist die erste Stirnfläche, auch Einkoppelfläche genannt, mit der die Koppeleinrichtung dem Messfeld und damit den zugehörigen Arrayelektroden zugewandt ist und die zweite Stirnfläche der Koppeleinrichtung, auch Auskoppelfläche genannt, die der Koppelelektrode zugewandt sind, jeweils parallel zueinander. In einer anderen, Bauraum sparenden Ausgestaltung ist Auskoppelfläche der Koppeleinrichtungen jeweils antiparallel zur Detektionsfläche, bevorzugt orthogonal zur Detektionsfläche.

Bevorzugt bildet der Ring eine Rastkontur für das Zusammenwirken mit wenigstens einer an der Handhabe ausgebildeten oder an der Handhabe befestigten Rastnase aus.

Die Erfindung betrifft ferner die Verwendung der Eingabevorrichtung in einer der zuvor beschriebenen Ausführungsformen in einem Kraftfahrzeug.

Die Erfindung wird anhand der nachfolgenden Figuren näher erläutert. Die Figuren sind dabei nur beispielhaft zu verstehen und stellen lediglich bevorzugte Ausführungsvarianten dar. Es zeigen:
- Fig. 1: eine perspektivische Aufsicht einer Ausführungsform der erfindungsgemäßen Eingabevorrichtung 1;
- Fig. 2: eine perspektivische Ansicht der zur erfindungsgemäßen Eingabevorrichtung gehörigen Lagermittel 7 und der damit verbundenen Koppeleinrichtungen 6a bis 6c in einer ersten Ausführungsform;
- Fig. 3: eine perspektivische Ansicht der zur erfindungsgemäßen Eingabevorrichtung gehörigen Lagermittel 7 und der damit verbundenen Koppeleinrichtungen 6a bis 6c in einer zweiten Ausführungsform;
- Fig. 4: eine perspektivische Ansicht der zur erfindungsgemäßen Eingabevorrichtung gehörigen Lagermittel 7 und der damit verbundenen Koppeleinrichtungen 6a bis 6c in einer dritten Ausführungsform;
- Fig. 5: eine perspektivische Ansicht der zur erfindungsgemäßen Eingabevorrichtung gehörigen Lagermittel 7 und der zugehörigen Handhabe 3 in einer vierten Ausführungsform;
- Fig. 6: eine weitere perspektivische Ansicht der zur erfindungsgemäßen Eingabevorrichtung gehörigen Lagermittel 7 und der zugehörigen Handhabe 3 in der vierten Ausführungsform.
- Fig. 7 bis 11: jeweils schematische Darstellung jeweils einer zugehörigen erfindungsgemäßen Detektionseinrichtung 2.

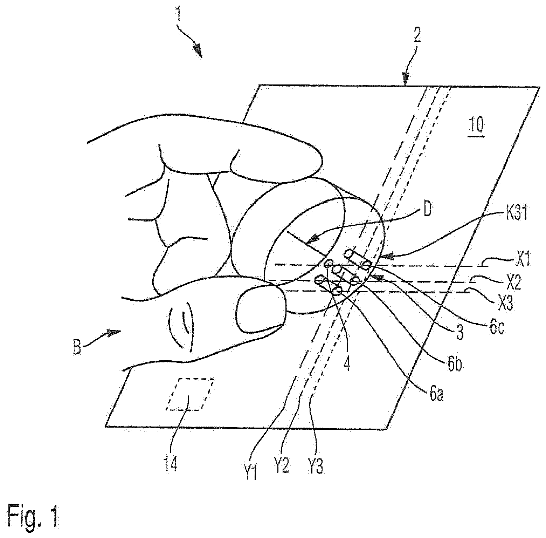

Figur 1 zeigt eine erfindungsgemäße Eingabevorrichtung 1 mit einem als kapazitive Detektionseinrichtung 2 fungierenden Touchscreen. Die Detektionseinrichtung 2 definiert eine dem Bediener B zugewandte Detektionsfläche 10, auf der eine Handhabe 3 um eine Drehachse D drehbeweglich mittels der in Figur 1 aus Gründen der besseren Anschauung nicht dargestellten Lagermittel gelagert angeordnet ist und somit einen sogenannten Drehsteller ausbildet. Die kapazitive Detektionseinrichtung 2 weist parallel verlaufende Arrayelektroden X1 bis X3 auf, sowie senkrecht dazu laufende Arrayelektroden Y1 bis Y3 auf. Das Gitte aus Arrayelektroden ist in den Figuren nicht vollständig und nicht maßstabsgetreu eingezeichnet und soll nur der schematischen Deutlichmachung des prinzipiellen Aufbaus dienen. Die Kreuzungspunkte der Elektroden X1 bis X3 mit den Elektroden Y1 bis Y3 bilden ein Array aus imaginären Knotenpunkten K11 bis K33. In der Figur ist aus Gründen der Übersichtlichkeit nur der Knotenpunkt K13, der durch den Kreuzungspunkt der Arrayelektroden X1 und Y3 definiert ist, bezeichnet. Die Nummerierung der weiteren Knotenpunkte ergibt sich analog dazu.

Mit den Elektroden Arrayelektroden X1 bis X3 und Y1 bis Y3 ist eine elektronische Auswerteinheit 14 elektrisch verbunden, die einige Elektroden, beispielsweise die Elektroden X1 bis X3 selektiv und in zeitlicher Abfolge zur Erzeugung eines zugehörigen Messfeldes mit jeweils einem Potenzial beaufschlagt, um anhand der Beeinflussung dieser Messfelder eine Berührung durch den Bediener B oder je nach Lage der betreffenden Knotenpunkte bezüglich der Handhabe 3 eine Stellung der Handhabe 3 zu detektieren. Zur Beeinflussung der betreffenden Messfelder weist die Handhabe 3 auf ihrer der Detektionsfläche 10 zugewandten Seite eine Koppelelektrode 4 auf, die in der vorliegenden Ausführungsform gegenüber dem Bediener B während dessen Berührung der Handhabe 3 elektrisch isoliert angeordnet ist. Es sind mehrere, insbesondere sich gleichmäßig über den Drehverstellungsbereich der Handhabe 3 verteilende Stellungen vorgesehen, von denen eine mögliche Stellung in der Figur 1 gezeigt ist.

Zur verbesserten kapazitiven Kopplung zwischen der Koppelelektrode 4 und den an den Knotenpunkten K11 bis K33 befindlichen Messfeldern sind je nach Stellung der Handhabe 3 mehrere stabförmige Koppeleinrichtungen 6a bis 6c aus leitfähigem Material, Metall, einem metallisch leitfähigen Material oder einer metallischen Legierung vorgesehen, von denen in Figur 1 zur besseren Anschauung lediglich drei gezeigt sind. Tatsächlich sind mehr als drei Koppeleinrichtungen, beispielsweise zwischen 10 und 50, bevorzugt 32, Koppeleinrichtungen 6a bis 6c vorgesehen, die in Umfangsrichtung um die Drehachse D gleichmäßig verteilt auf der Detektionsfläche 10 angeordnet sind. Die Koppeleinrichtungen 6a bis 6c dienen bei entsprechender Stellung der Handhabe 3 der Bereitstellung von kapazitiven Kopplungen zwischen der Koppelelektrode 4 und den zu der jeweiligen Koppeleinrichtung 6a bis 6c zugeordneten Knotenpunkten K11 bis K33, so dass es zu einer Beeinflussung der jeweiligen Messfelder im Bereich der Knotenpunkte K11 bis K33 kommt, was von der Auswerteinheit 14 detektierbar ist und der Stellungsdetektion der Auswerteinheit 14 dient, so dass diese eine Stellungsinformation auszugeben vermag.

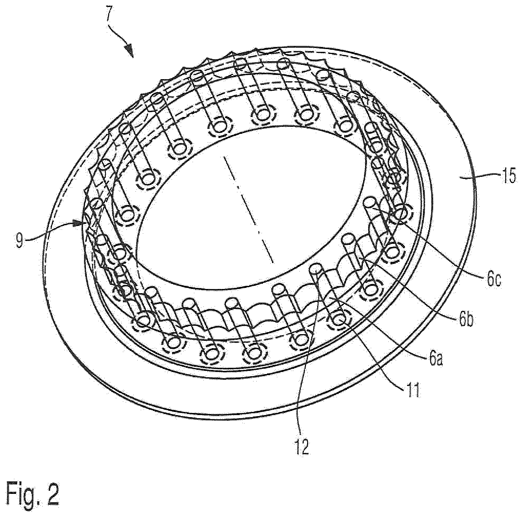

Figur 2 zeigt eine erste Ausführungsform der Lagermittel 7, wobei die Koppeleinrichtungen 6a bis 6c in dem Material der Lagermittel 7 durch Umspritzen der Koppeleinrichtungen 6a bis 6 mit dem Material der Lagermittel 7 formschlüssig aufgenommen sind. Die Lagermittel 7 bilden einen Ring aus Thermoplast aus, in denen die stabförmigen Koppeleinrichtungen 6 a bis 6c aufgenommen sind. Der Ring weist einen Flansch 15 auf, der der Anordnung und Befestigung, beispielsweise stoffschlüssigen Verbindung, mit der in Figur 1 gezeigten Detektionsfläche 10 dient. Die stabförmigen Koppeleinrichtungen 6 a bis 6c bilden jeweils eine untere Stirnfläche 11, die jeweils einer der in Figur 1 gezeigten Arrayelektroden 5a bis 5c zugewandt ist, und eine obere Stirnfläche 12 aus, die der in Figur 1 gezeigten Koppelelektrode 4 zugewandt ist. Beide Stirnflächen 11, 12 sind bei der in Figur 2 gezeigten, ersten Ausführungsform jeweils parallel zur in Figur 1 gezeigten Detektionsfläche 10. Die als Ring ausgebildeten Lagermittel 7 weisen auf ihrem Außenumfang eine Rastkontur 9 auf, die mit einer an der in Figur 1 gezeigten Handhabe 3 befestigten oder von der Handhabe 3 ausgebildeten und im Detail nicht dargestellten Rastnase zusammenwirkt, um eine beim Verstellen der Handhabe 3 für den Bediener B haptisch wahrnehmbare Rasthaptik zu erzeugen.

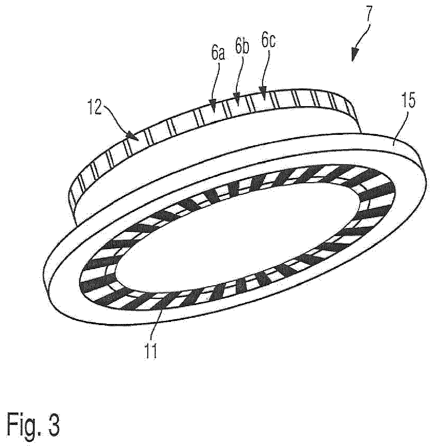

Figur 3 zeigt eine zweite Ausführungsform der Lagermittel 7 in denen die Koppeleinrichtungen 6a bis 6c ebenfalls durch Umspritzen formschlüssig aufgenommen sind. Die Lagermittel 7 bilden auch hier einen Ring aus Thermoplast aus, in denen die Koppeleinrichtungen 6 a bis 6c aufgenommen sind, Der Ring weist wiederum einen Flansch 15 auf, der der Anordnung und Befestigung, beispielsweise stoffschlüssigen Verbindung, mit der in Figur 1 gezeigten Detektionsfläche 10 dient. Die Koppeleinrichtungen 6 a bis 6c bildet jeweils eine untere rechteckige Stirnfläche 11 aus, die jeweils einer der in Figur 1 gezeigten Arrayelektroden 5a bis 5c zugewandt ist. Sie bildet ferner eine obere, rechteckige Stirnfläche 12 aus, die der in Figur 1 gezeigten Koppelelektrode 4 zugewandt ist.

Während die untere Stirnfläche 11 jeweils parallel zur in Figur 1 gezeigten Detektionsfläche 10 ist, ist die obere, der Koppelelektrode 4 zugewandte Stirnfläche 12 orthogonal zu beiden. Die als Ring ausgebildeten Lagermittel 7 weisen wiederum auf ihrem Außenumfang eine Rastkontur 9 auf, die mit einer an der in Figur 1 gezeigten Handhabe 3 befestigten oder von der Handhabe 3 ausgebildeten und im Detail nicht dargestellten Rastnase zusammenwirkt, um eine beim Verstellen der Handhabe 3 für den Bediener B haptisch wahrnehmbare Rasthaptik zu erzeugen.

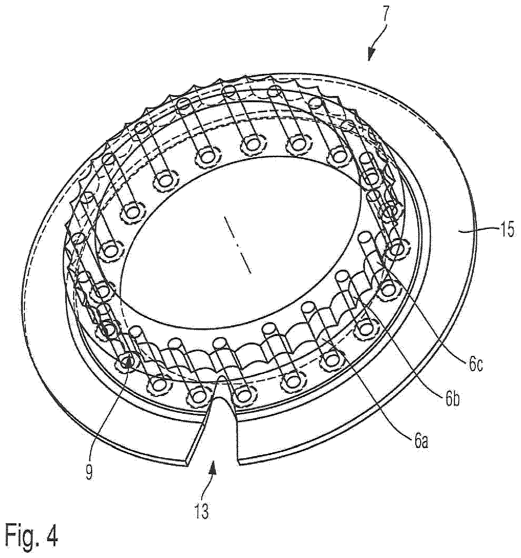

Figur 4 zeigt eine dritte, an die erste Ausführungsform angelehnte Ausführungsform der Lagermittel 7. Hierbei sind wiederum die Koppeleinrichtungen 6a bis 6c durch Umspritzen formschlüssig in den Lagermitteln 7 aufgenommen. Die Lagermittel 7 bilden auch hier einen Ring aus Thermoplast aus, in denen die Koppeleinrichtungen 6 a bis 6c aufgenommen sind. Der Ring weist wiederum einen Flansch 15 auf, der der Anordnung und Befestigung, beispielsweise stoffschlüssigen Verbindung, mit der in Figur 1 gezeigten Detektionsfläche 10 dient. Die Koppeleinrichtungen 6 a bis 6c bilden jeweils eine untere rechteckige Einkoppelfläche 11, die jeweils einer der in Figur 1 gezeigten Arrayelektroden 5a bis 5c zugewandt ist, und eine obere, rechteckige Stirnfläche 12 auch Auskoppelfläche oder Kontaktfläche genannt, aus, die der in Figur 1 gezeigten Koppelelektrode 4 zugewandt ist. Während die untere Stirnfläche 11 jeweils parallel zur in Figur 1 gezeigten Detektionsfläche 10 ist, ist die obere, der Koppelelektrode 4 zugewandte Stirnfläche 12 orthogonal zu beiden. Die als Ring ausgebildeten Lagermittel 7 weisen wiederum auf ihrem Außenumfang eine Rastkontur 9 auf, die mit einer an der in Figur 1 gezeigten Handhabe 3 befestigten und von der Handhabe 3 ausgebildeten und im Detail nicht dargestellten Rastnase zusammenwirkt, um eine beim Verstellen der Handhabe 3 für den Bediener B haptisch wahrnehmbare Rasthaptik zu erzeugen. Im Unterschied zur ersten Ausführungsform ist eine seitliche, den Flansch 15 durchgreifende Ausnehmung 13 in den Lagermitteln 7 ausgebildet, die dem Abfluss von einem Fluid dient, dass sich möglicherweise und unerwünscht in dem Innern des Rings ansonsten ansammeln könnte.

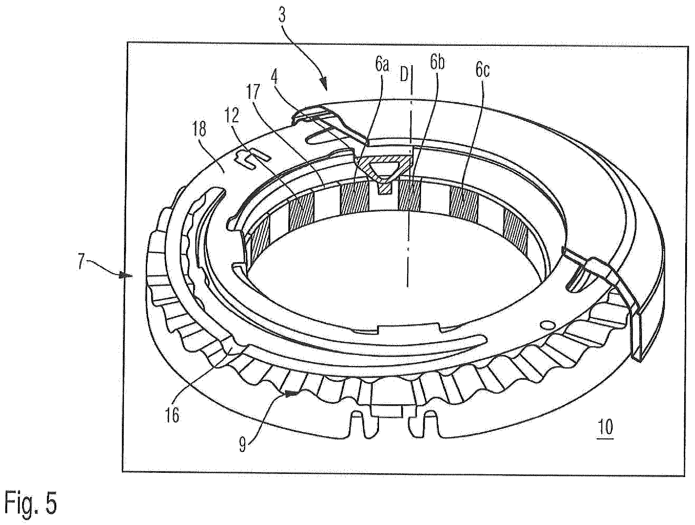

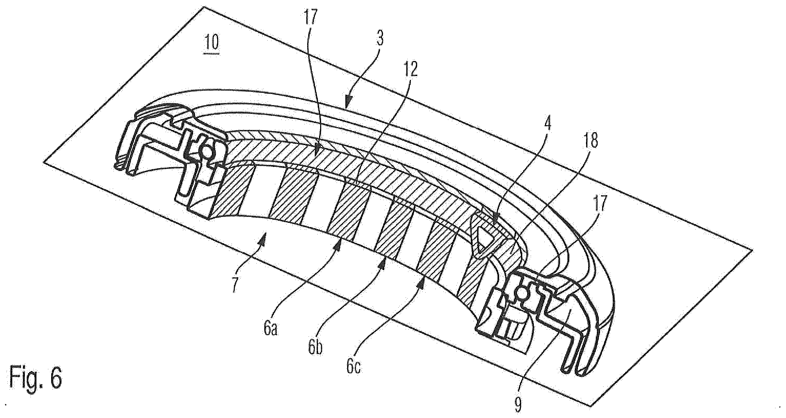

Die Figuren 5 und 6 zeigen die Lagermittel 7 und die Handhabe 3 einer vierten Ausführungsform der erfindungsgemäßen Eingabevorrichtung. Diese weist ein leitfähiges Blech 18, das als Stanz-Biegeteil ausgebildet ist. Die Handhabe 3 ist über ein zu den Lagermitteln 7 gehöriges Kugellager 17, welches elektrisch mit dem leitfähigen Blech 18 verbunden ist, drehbeweglich auf der zur nicht dargestellten Detektionseinrichtung gehörigen Detektionsfläche 10 gelagert. Das Blech 18 und das Kugellager 17 bilden zusammen die Koppelelektrode 4 aus. Die Lagermittel 7 weisen eine Rastkontur 9 auf, in die eine an der Handhabe 3 ausgebildete Rastnase 16 in einer zur Drehachse D parallelen Richtung zur Erzeugung einer Rasthaptik eingreift. Die von der Koppelelektrode 4 jeweils stellungsabhängig elektrisch kontaktierten Koppeleinrichtungen 6a, 6b, 6c sind als galvanisierte Schicht ausgebildet, die auf einer Innenumfangsfläche der als Ring ausgebildeten Lagermittel 7 aufgebracht sind und jeweils eine Kontaktfläche 12 definieren, die der Koppelelektrode 4 zugewandt ist. Die Handhabe 3 ist durch einen hier nicht dargestellten Mechanismus in Bezug zur Detektionsfläche 10 rückstellend aus einer Ruhestellung in mehrere Endstellungen verkippbar gelagert. In den Endstellungen kommt das Kugellager 17 mehreren der Auskoppelflächen bzw. Kontaktflächen 12 sehr nahe oder berührt diese, wodurch eine zweite kapazitive Kopplung bzw. ein elektrischer Kontakt zwischen der Koppelelektrode 4 und mehreren Koppeleinrichtungen 6a bis 6c und damit zu mehreren hier nicht näher gezeigten Messfeldern eines hier nicht gezeigten Multibereichs hergestellt wird.

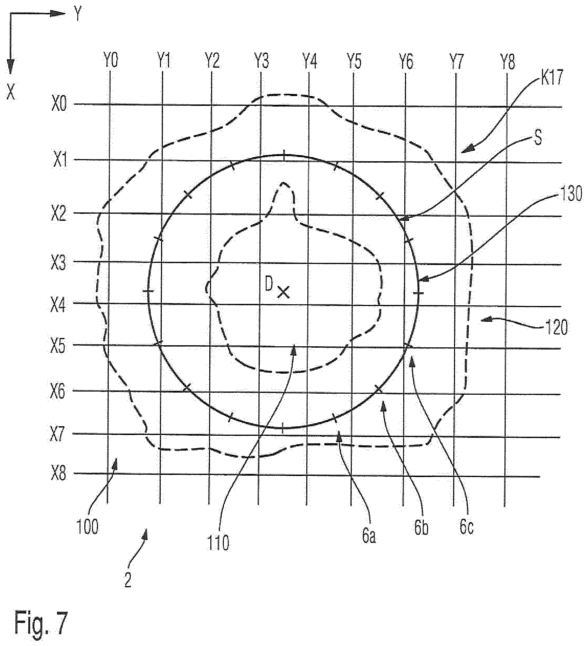

Die Figuren 7 bis 11 zeigen eine schematische Darstellung einer erfindungsgemäßen Detektionseinrichtung 2 mit Detektionsfläche 100 sowie jeweils einem Gitter aus parallel verlaufenden Arrayelektroden X0 bis X8 und von diesen elektrisch isolierten, diese jeweils kreuzenden Arrayelektroden Y0 bis Y8. Hierbei handelt es sich um die Elektroden einer kapazitiven Detektionseinrichtung 2 in projiziert-kapazitiver Technologie, insbesondere um eine solche im mutual-capacitance Aufbau. Bei diesem Aufbau werden Messfelder und somit Messkapazitäten an den Kreuzungspunkten zwischen jeweils zwei elektrisch isolierten, sich kreuzenden Elektrodenstrukturen erzeugt. Die Kreuzungspunkte werden hier als Knotenpunkte K00 bis K88 bezeichnet und sind in einem rechtwinkligen Gitter angeordnet. In den Figuren 7 bis 11 sind aus Gründen der Übersichtlichkeit nur der Knotenpunkt K17, der durch den Kreuzungspunkt der Arrayelektroden X1 und Y7 definiert ist bezeichnet. Die Nummerierung der weiteren Knotenpunkte ergibt sich analog dazu.

Ein hier nicht gezeigte elektrisch mit den Arrayelektroden verbundene, bevorzugt elektrisch leitend verbundene, elektronische Auswerteinheit 14 ist in der Lage, die Beeinflussung des kapazitiven Messfeldes jedes einzelnen Knotenpunkts zu messen. Wenn das jeweilige Messfeld durch eine äußere Annäherung eines Objekts beeinflusst wird, wird die durch die Auswerteinheit gemessene elektrische Messkapazität am betreffenden Knotenpunkt verändert und detektiert und kann aufgrund der nach Reihen und Spalten gegliederten Elektrodenstruktur und Schnittpunktanordnung einem Ort auf der Detektionsfläche zugeordnet werden.

Die Figuren zeigen weiterhin eine zur Detektionsfläche orthogonale Drehachse D um welche eine hier nicht gezeigte Handhabe 3 drehbeweglich an der Detektionsfläche entlang eines durch die Anordnung der Koppeleinrichtungen beschriebenen Stellwegs S gelagert ist. Der Stellweg S umschließt somit einen kreisrunden Innenbereich 110 der Detektionsfläche 100. Der Teil der Detektionsfläche 100, der außerhalb des Stellwegs S liegt, ist der Außenbereich 120. Den Stellweg S senkrecht kreuzende, kleine Linien symbolisieren auf der Detektionsfläche 100 angeordnete Koppeleinrichtungen 6a bis 6c. Über die Koppeleinrichtungen gibt es je nach Stellung der Koppelelektrode 4 kapazitive Kopplungen zwischen mehreren Knotenpunkten K00 bis K88 und der Koppelelektrode 4. Dabei liegt die Gesamtheit der Knotenpunkte K00 bis K88 die bei irgendeiner der möglichen Stellungen der Koppelelektrode 4 kapazitiv zur Koppelelektrode 4 koppeln, innerhalb eines Teilbereichs der Detektionsfläche 100, den sogenannten Beeinflussungsbereichs 130. Anders ausgedrückt, alle Knotenpunkte K00 bis K88, die kapazitiv durch die Koppelelektrode 4 beeinflusst werden können, liegen innerhalb des Beeinflussungsbereichs 130.

Sowohl im Innenbereich 110 als auch im Außenbereich 120 gibt es Knotenpunkte K00 bis K88, die nicht im Beeinflussungsbereich 130 liegen. Diese Knotenpunkte K00 bis K88 können für zur Detektion weiterer Funktionalitäten der Eingabevorrichtung 1, wie beispielsweise eine Erkennung einer Berührung durch den Benutzer oder dergleichen, genutzt werden.

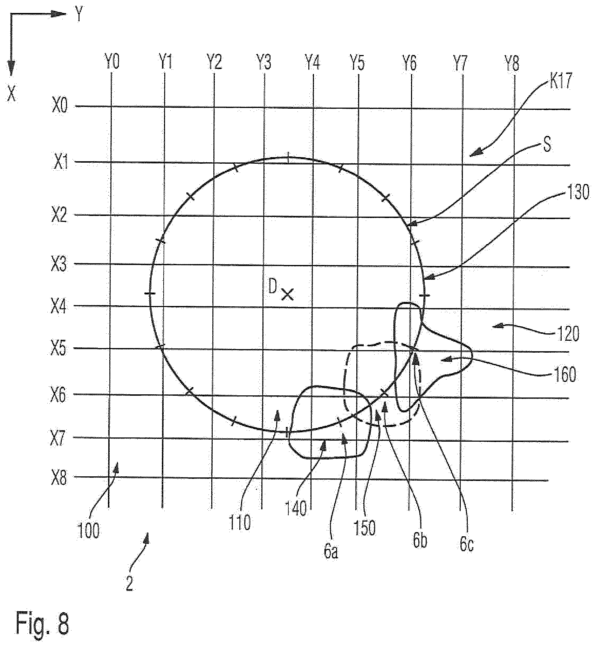

In Figur 8 werden insbesondere die den Koppeleinrichtungen 6a, 6b und 6c jeweils zugeordneten Teilbereiche 140, 150 und 160 gezeigt. Dabei ist die Koppeleinrichtung 6a von den vier Knotenpunkte K64, K65, K74 und K75 umgeben. Bei einer Stellung, bei der die hier nicht gezeigte Koppelelektrode 4 nächstbenachbart zur Koppeleinrichtung 6a ist, finden kapazitive Kopplungen zwischen diesen Knotenpunkte K64, K65, K74 und K75 und der Koppelelektrode 4 statt, welche von der Auswerteinheit 14 detektiert werden. Analoges gilt für die den Koppeleinrichtungen 6b und 6c zugeordneten Teilbereiche 150 und 160. Je nachdem in welchem Teilbereich 140, 150, 160 die Auswerteinheit kapazitive Kopplungen detektiert, kann die Auswerteinheit 14 eine Stellungs- und/oder eine Bewegungsinformation der Handhabe 3 erhalten und ausgeben.

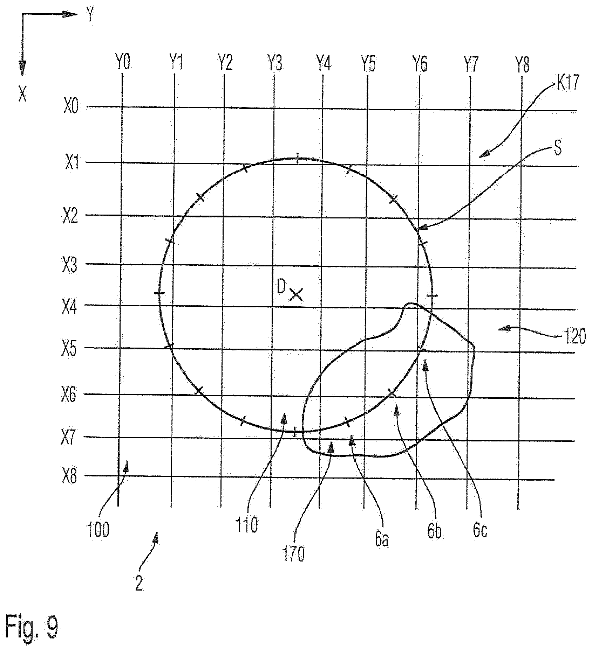

In Figur 9 wird insbesondere der den Koppeleinrichtungen 6a, 6b und 6c zugeordneten Multibereich 170 gezeigt. Der Multibereich setzt sich dabei aus den drei Teilbereichen 140, 150 und 160 zusammen und stellt somit deren Vereinigungsmenge dar. In einer Stellung der Handhabe 3, beispielsweise einer Verkippstellung, in welcher die Koppelelektrode nächstbenachbart zu den drei Koppeleinrichtungen 6a, 6b und 6c ist, werden alle Knotenpunkte K00 bis K88, welche innerhalb dieses Multibereichs liegen, kapazitiv beeinflusst. Dies wird mittels der Auswerteinheit 14 detektiert und kann aus dieser Information eine richtungsspezifische - nämlich "rechts-unten" - Kippinformation erhalten und ausgeben.

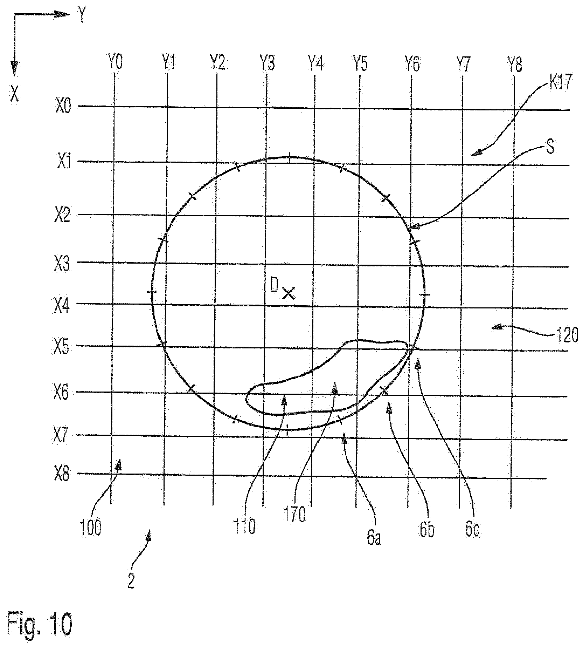

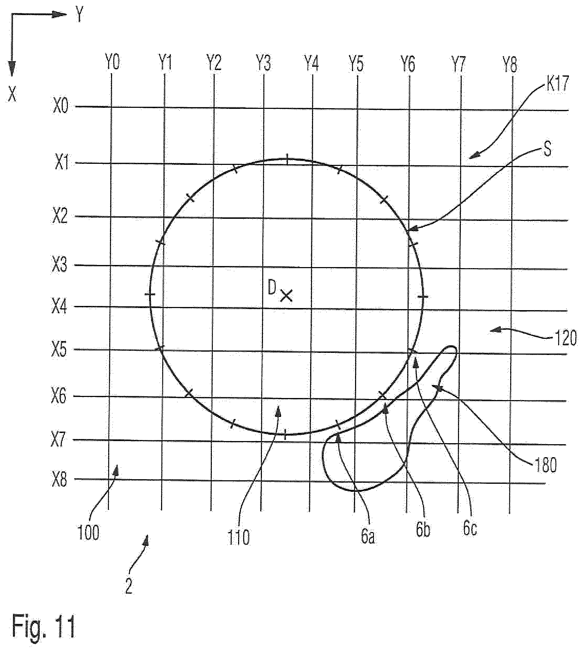

In den Figuren 10 und 11 werden Situation dargestellt, in denen eine kapazitive Beeinflussung durch Wasser vorliegt. In Figur 10 liegt dabei ein nicht gezeigter Wassertropfen innerhalb eines kleinen Bereichs 170 der im Innenbereich 110 der Detektionsfläche 100. Kapazitive Kopplungen zwischen dem Wassertropfen und den Knotenpunkten finden nur innerhalb dieses Bereichs statt. Analoges gilt für einen Wassertropfen, der wie in Figur 11 gezeigt in einem kleinen Bereich 180 innerhalb des Außenbereichs 120 der Detektionsfläche liegt. Demnach werden in beiden Situationen jeweils nur Knotenpunkte in Teilen der Teilbereiche 140, 150, 160 und des Multibereichs 170 kapazitiv beeinflusst. Die kann von der Auswerteinheit 14 detektiert werden. Die Detektionsergebnisse können dann weiter von der Auswerteinheit benutzt werden um einen Störeinfluss auf die Eingabevorrichtung festzustellen.

## Patentansprüche

1. Eingabevorrichtung (1) aufweisend:
eine kapazitive Detektionseinrichtung (2), welche eine Detektionsfläche (10, 100) unter Ausbildung eines der Detektionsfläche (10, 100) zugeordneten Arrays von Arrayelektroden (X0 bis X8, Y0 bis Y8), aufweist;
eine elektrisch mit den Arrayelektroden (X0 bis X8, Y0 bis Y8) verbundene, elektronische Auswerteinheit (14), um mittels des Arrays von Arrayelektroden (X0 bis X8, Y0 bis Y8) ein zugehöriges Array von elektrischen Messfeldern zur ortsauflösenden Detektion einer kapazitiven Beeinflussung auf der Detektionsfläche (10, 100) auszubilden;
eine Handhabe (3), die entlang eines Stellwegs (S) unter Bereitstellung eines ersten Bewegungsfreiheitsgrades beweglich auf der Detektionsfläche (10, 100) mittels Lagermittel (7) angeordnet ist, um eine Bedieneingabe mittels Bewegung, beispielsweise unter Berührung der Handhabe (3) durch einen Bediener (B), vorzunehmen;
eine mit der Handhabe (3) entlang des Stellwegs (S) mindestens teilweise mitbewegte
Koppelelektrode (4); und
mehrere, entlang des Stellwegs (S) verteilt, auf der Detektionsfläche (10, 100) mittels der Lagermittel (7) angeordnete, jeweils elektrisch isolierte Koppeleinrichtungen (6a, 6b, 6c) aus leitfähigem Material, die jeweils so angeordnet und ausgebildet sind, dass jeweils mehrere benachbarte Messfelder mit einer zugehörigen Koppeleinrichtung der mehreren Koppeleinrichtungen (6a, 6b, 6c) kapazitiv koppeln, wobei die zu einer Koppeleinrichtung (6a, 6b, 6c) zugeordneten Messfelder jeweils genau einen, bevorzugt zusammenhängenden, Teilbereich (140, 150, 160) der Detektionsfläche (10, 100) definieren; und
wobei mehrere Stellungen der Handhabe (3) entlang deren Stellwegs (S) vorgesehen sind, bei der die Koppelelektrode (4) stellungsabhängig zu wenigstens einer der Koppeleinrichtungen (6a, 6b, 6c) nächstbenachbart angeordnet ist, um stellungsabhängig diese Koppeleinrichtung (6a, 6b, 6c) elektrisch zu kontaktieren oder mit dieser wenigstens kapazitiv zu koppeln;
und wobei die elektronische Auswerteinheit (14) ausgebildet ist, die durch die kapazitive Kopplung bewirkte stellungsabhängige Beeinflussung der Messfelder zu detektieren, um eine Stellungsinformation der Handhabe (3) zu erhalten und auszugeben.

2. Eingabevorrichtung (1) gemäß dem vorhergehenden Anspruch, wobei die Anordnung und Lage der Arrayelektroden (X0 bis X8, Y0 bis Y8) durch eine regelmäßige, bevorzugt rechtwinklige, gedachte Gitterstruktur beschrieben ist und die Lage der Messfelder durch die Knotenpunkte (K00 bis K88) der Gitterstruktur definiert ist.

3. Eingabevorrichtung (1) gemäß einem der vorhergehenden Ansprüche, wobei die Handhabe (3) in Bezug zur Detektionsfläche (10, 100) rückstellend aus einer Ruhestellung in eine Endstellung gegenüber der Detektionsfläche (10, 100) unter Bereitstellung eines zweiten Bewegungsfreiheitsgrades rückstellend verlagerbar ist, nämlich bezüglich einer zur Detektionsfläche orthogonalen gedachten Achse verkippbar und/ oder verschiebbar gelagert ist, wobei die Endstellung jeweils so gewählt ist, dass in der Endstellung die Koppelelektrode mehrere Koppeleinrichtungen elektrisch kontaktiert oder mit mehreren Koppeleinrichtungen kapazitiv koppelt, so es zur kapazitiven Beeinflussung mehrerer, mehreren Teilbereichen zugeordneten Messfeldern kommt, die insgesamt einen, bevorzugt zusammenhängenden, Multibereich (170) der Detektionsfläche (10, 100) definieren; und wobei die elektronische Auswerteinheit (14) ausgebildet ist, die durch die Verlagerung in die Endstellung bewirkte kapazitive Beeinflussung der zum Multibereich (170) gehörigen Messfelder zu detektieren, um ferner eine Verlagerungsinformation der Handhabe (3) zu erhalten und auszugeben.

4. Eingabevorrichtung (1) gemäß dem vorhergehenden Anspruch, wobei die dem Multibereich (170) zugeordneten Koppeleinrichtungen (6a, 6b, 6c) nächstbenachbart zueinander liegen.

5. Eingabevorrichtung (1) gemäß einem der beiden vorhergehenden Ansprüche, wobei die Handhabe (3) in Bezug zur Detektionsfläche (10, 100) in mehrere unterschiedliche, richtungsspezifische Endstellungen verlagerbar ist, und pro richtungsspezifischer Endstellungen jeweils ein richtungsspezifischer Multibereich (170) vorgesehen ist und die elektronische Auswerteinheit (14) ausgebildet ist, die durch die Verlagerung in die jeweilige richtungsspezifische Endstellung bewirkte kapazitive Beeinflussung der zu den richtungsspezifischen Multibereichen (170) gehörigen Messfelder zu detektieren, um eine richtungsspezifische Verlagerungsinformation der Handhabe (3) zu erhalten und auszugeben.

6. Eingabevorrichtung (1) gemäß einem der vorhergehenden Ansprüche, wobei die Koppelelektrode (4) zumindest teilweise aus einem Kugellager (17) besteht.

7. Eingabevorrichtung (1) gemäß einem der vorhergehenden Ansprüche, wobei die Handhabe (3) um eine zur Detektionsfläche (10) orthogonale Drehachse (D) beweglich an der Detektionsfläche (10) mittels der Lagermittel (7) gelagert ist und der durch die Anordnung der Koppeleinrichtungen (6a, 6b, 6c) beschrieben Stellweg (S) einen im Wesentlichen kreisrunden Innenbereich (110) der Detektionsfläche definiert.

8. Eingabevorrichtung (1) gemäß dem vorhergehenden Anspruch, wobei im Innenbereich (110) mindestens ein, bevorzugt mehrere, außerhalb aller Teilbereiche (140, 150, 160) und aller Multibereiche (170) liegende Messfelder vorgesehen sind.

9. Eingabevorrichtung (1) gemäß einem der Ansprüche 8 oder 9, wobei die mehreren Koppeleinrichtungen (6a, 6b, 6c) um die Drehachse (D) verteilt angeordnet sind.

10. Eingabevorrichtung (1) gemäß einem der vorhergehenden Ansprüche, wobei die mehreren Koppeleinrichtungen (6a bis 6c) an den Lagermitteln (7) befestigt sind.

11. Eingabevorrichtung (1) gemäß dem vorhergehenden Anspruch, wobei die mehreren Koppeleinrichtungen (6a bis 6c) form-, kraft- und/oder stoffschlüssig mit den Lagermitteln (7) verbunden sind.

12. Eingabevorrichtung (1) gemäß einem der vorhergehenden Ansprüche, wobei die Lagermittel (7) einen Ring aus Kunststoff ausbilden in dem die mehreren Koppeleinrichtungen (6a bis 6c) aufgenommen sind.

13. Eingabevorrichtung (1) gemäß dem vorhergehenden Anspruch, wobei der Ring eine Rastkontur (9) für das Zusammenwirken mit wenigstens einer an der Handhabe (3) ausgebildeten Rastnase ausbildet.

14. Eingabevorrichtung (1) gemäß einem der vorhergehenden Ansprüche, wobei die kapazitive Detektionseinrichtung (2) ein Touchpad oder ein Touchscreen ist.

15. Verwendung der Eingabevorrichtung (1) gemäß einem der vorhergehenden Ansprüche in einem Kraftfahrzeug.

## Claims

1. Input device (1), having:
a capacitive detection device (2), which has a detection surface (10, 100) while forming an array of array electrodes (XO to X8, Y0 to Y8) associated with the detection surface (10, 100);
an electronic evaluation unit (14), which is electrically connected to the array electrodes (XO to X8, Y0 to Y8) in order to form, by means of the array of array electrodes (XO to X8, Y0 to Y8), an associated array of electrical measuring fields for the spatially resolved detection of a capacitive influence on the detection surface (10, 100);
a handle (3), which, providing a first degree of freedom of movement, is arranged on the detection surface (10, 100) by bearing means (7) such that it can be moved along an adjustment path (S) in order to perform an operating input by means of movement, for example with the handle (3) being touched by an operator (B);
a coupling electrode (4) at least partially moved along the adjustment path (S) with the handle (3); and
a plurality of respectively electrically insulated coupling devices (6a, 6b, 6c) made of conductive material, which are distributed along the adjustment path (S) and arranged on the detection surface (10, 100) by the bearing means (7), and which are each arranged and formed such that a plurality of adjacent measuring fields are each coupled capacitively to an associated coupling device of the plurality of coupling devices (6a, 6b, 6c), wherein the measuring fields associated with a coupling device (6a, 6b, 6c) each define exactly one, preferably coherent, partial area (140, 150, 160) of the detection surface (10, 100); and wherein a plurality of positions of the handle (3) along its adjustment path (S) are provided, in which the coupling electrode (4) is arranged most closely adjacent to at least one of the coupling devices (6a, 6b, 6c), depending on the position, in order to make electrical contact with or at least to couple capacitively to this coupling device (6a, 6b, 6c), depending on the position, and wherein the electronic evaluation unit (14) is designed to detect the position-dependent influence on the measuring fields effected by the capacitive coupling, in order to obtain and output position information about the handle (3).

2. Input device (1) according to the preceding claim, wherein
the arrangement and position of the array electrodes (XO to X8, Y0 to Y8) is described by a regular, preferably rectangular, imaginary grid structure, and the position of the measuring fields is defined by the junctions (K00 to K88) of the grid structure.

3. Input device (1) according to either of the preceding claims, wherein the handle (3), providing a second degree of freedom of movement, can be displaced in a restoring manner in relation to the detection surface (10, 100) in a restoring manner from a rest position into an end position opposite the detection surface (10, 100), namely is supported such that it can be tilted and/or displaced with respect to an imaginary axis orthogonal to the detection surface, wherein the end position is in each case chosen such that, in the end position, the coupling electrode makes contact with or couples capacitively to a plurality of coupling devices, so that a capacitive influence is exerted on a plurality of measuring fields associated with a plurality of partial areas which, overall, define a preferably coherent multiple area (170) of the detection surface (10, 100); and wherein the electronic evaluation unit (14) is designed to detect the capacitive influence on the measuring fields belonging to the multiple area (170) effected by the displacement into the end position, in order in addition to obtain and output displacement information about the handle (3).

4. Input device (1) according to the preceding claim, wherein the coupling devices (6a, 6b, 6c) associated with the multiple area (170) are located most closely adjacent to one another.

5. Input device (1) according to one of the two preceding claims, wherein the handle (3) can be displaced into a plurality of different, direction-specific end positions in relation to the detection surface (10, 100) and, for each direction-specific end position, a direction-specific multiple area (170) is provided and the electronic evaluation unit (14) is designed to detect the capacitive influence on the measuring fields belonging to the direction-specific multiple areas (170), effected by the displacement into the respective direction-specific end position, in order to obtain and output direction-specific displacement information about the handle (3).

6. Input device (1) according to one of the preceding claims, wherein the coupling electrode (4) consists at least partly of a ball bearing (17).

7. Input device (1) according to one of the preceding claims, wherein the handle (3) is mounted on the detection surface (10) by the bearing means (7) such that it can be moved about an axis of rotation (D) orthogonal to the detection surface (10), and the adjustment path (S) described by the arrangement of the coupling devices (6a, 6b, 6c) defines a substantially circular inner area (110) of the detection surface.

8. Input device (1) according to the preceding claim, wherein at least one, preferably a plurality of measuring fields located outside all the partial areas (140, 150, 160) and all the multiple areas (170) are provided in the inner area (110).

9. Input device (1) according to either of Claims 8 and 9, wherein the plurality of coupling devices (6a, 6b, 6c) are arranged so as to be distributed about the axis of rotation (D).

10. Input device (1) according to one of the preceding claims, wherein the plurality of coupling devices (6a, 6b, 6c) are fixed to the bearing means (7).

11. Input device (1) according to the preceding claim, wherein the plurality of coupling devices (6a, 6b, 6c) are connected to the bearing means (7) in a form-fitting, force-fitting and/or integral manner.

12. Input device (1) according to one of the preceding claims, wherein the bearing means (7) form a ring made of plastic, in which the plurality of coupling devices (6a, 6b, 6c) are accommodated.

13. Input device (1) according to the preceding claim, wherein the ring forms a latching contour (9) for the cooperation with at least one latching lug formed on the handle (3).

14. Input device (1) according to one of the preceding claims, wherein the capacitive detection device (2) is a touch pad or a touch screen.

15. Use of the input device (1) according to one of the preceding claims in a motor vehicle.

## Revendications

1. Arrangement de saisie (1) comprenant :
un dispositif de détection capacitif (2), lequel possède une surface de détection (10, 100) en formant une matrice d'électrodes en matrice (XO à X8, Y0 à Y8) associée à la surface de détection (10, 100) ;
une unité d'interprétation (14) électronique, reliée électriquement aux électrodes en matrice (XO à X8, Y0 à Y8), en vue de former, au moyen de la matrice d'électrodes en matrice (XO à X8, Y0 à Y8), une matrice correspondante de champs de mesure électriques destinés à la détection avec résolution locale d'une influence capacitive sur la surface de détection (10, 100) ;
une manette (3), laquelle est disposée sur la surface de détection (10, 100) par le biais de moyens d'appui (7) avec mobilité le long d'une course de réglage (S) en fournissant un premier degré de liberté, afin d'effectuer une saisie de commande au moyen d'un mouvement, par exemple par le toucher de la manette (3) par un opérateur (B) ;
une électrode de couplage (4) qui accompagne au moins partiellement le mouvement de la manette (3) le long de la course de réglage (S) ; et
plusieurs dispositifs de couplage (6a, 6b, 6c) en un matériau conducteur, respectivement isolés électriquement, distribués le long de la course de réglage (S) et disposés sur la surface de détection (10, 100) par le biais des moyens d'appui (7), lesquels sont respectivement disposés et configurés de telle sorte que plusieurs champs de mesures voisins se couplent de manière capacitive respectivement avec un dispositif de couplage associé des plusieurs dispositifs de couplage (6a, 6b, 6c), les champs de mesure associés à un dispositif de couplage (6a, 6b, 6c) définissant respectivement exactement une zone partielle (140, 150, 160), de préférence continue de la surface de détection (10, 100) ; et plusieurs positions de la manette (3) étant prévues le long de la course de réglage (S), avec lesquelles l'électrode de couplage (4) est, en fonction de la position, disposée dans le voisinage immédiat d'au moins l'un des dispositifs de couplage (6a, 6b, 6c) afin d'entrer en contact électrique avec ce dispositif de couplage (6a, 6b, 6c) ou être couplé de manière capacitive avec celui-ci en fonction de la position ;
et l'unité d'interprétation (14) électronique étant configurée pour détecter l'influence sur les champs de mesure provoquée en fonction de la position par le couplage capacitif afin d'obtenir et de délivrer en sortie une information de position de la manette (3).

2. Arrangement de saisie (1) selon la revendication précédente, la disposition et la position des électrodes en matrice (XO à X8, Y0 à Y8) étant décrites par une structure en grille imaginaire régulière, de préférence à angles droits, et la position des champs de mesure étant définie par les points nodaux (K00 à K88) de la structure en grille.

3. Arrangement de saisie (1) selon l'une des revendications précédentes, la manette (3) pouvant, en référence à la surface de détection (10, 100), être positionnée par rappel par rappel depuis une position de repos en une position finale par rapport à la surface de détection (10, 100) en fournissant un deuxième degré de liberté, à savoir supportée basculante et/ou coulissante par rapport à un axe imaginaire orthogonal à la surface de détection, la position finale étant respectivement choisie de telle sorte que dans la position finale, l'électrode de couplage entre en contact électrique avec plusieurs dispositifs de couplage ou est couplée de manière capacitive avec plusieurs dispositifs de couplage, de sorte qu'il se produit une influence capacitive de plusieurs champs de mesure, associés à plusieurs zones partielles qui, ensemble, définissent une zone multiple (170), de préférence continue, de la surface de détection (10, 100) ; et l'unité d'interprétation (14) électronique étant configurée pour détecter l'influence capacitive des champs de mesure qui font partie de la zone multiple (170), provoquée par le déplacement dans la position finale, afin d'obtenir et de délivrer en sortie en plus une information de déplacement de la manette (3).

4. Arrangement de saisie (1) selon la revendication précédente, les dispositifs de couplage (6a, 6b, 6c) associés à la zone multiple (170) se trouvant dans le voisinage immédiat les uns des autres.

5. Arrangement de saisie (1) selon l'une des deux revendications précédentes, la manette (3) pouvant être déplacée dans différentes positions finales, spécifiques à la direction, par rapport à la surface de détection (10, 100), et une zone multiple (170) spécifique à la direction étant respectivement prévue pour chaque position finale spécifique à la direction et l'unité d'interprétation (14) électronique étant configurée pour détecter l'influence capacitive des champs de mesure qui font partie des zones multiples (170) spécifiques à la direction, provoquée par le déplacement dans la position finale spécifique à la direction respective, afin d'obtenir et de délivrer en sortie une information de déplacement de la manette (3) spécifique à la direction.

6. Arrangement de saisie (1) selon l'une des revendications précédentes, l'électrode de couplage (4) se composant au moins partiellement d'un roulement à billes (17).

7. Arrangement de saisie (1) selon l'une des revendications précédentes, la manette (3) étant supportée au niveau de la surface de détection (10) par le biais de moyens d'appui (7) avec mobilité autour d'un axe de rotation (D) orthogonal à la surface de détection (10) et la course de réglage (S) décrite par la disposition des dispositifs de couplage (6a, 6b, 6c) définissant une zone intérieure (110) sensiblement circulaire de la surface de détection.

8. Arrangement de saisie (1) selon la revendication précédente, au moins un, de préférence plusieurs champs de mesure, qui se trouvent à l'extérieur de toutes les zones partielles (140, 150, 160) et de toutes les zones multiples (170), étant présent dans la zone intérieure (110).

9. Arrangement de saisie (1) selon l'une des revendications 8 et 9, les plusieurs dispositifs de couplage (6a, 6b, 6c) étant répartis autour de l'axe de rotation (D).

10. Arrangement de saisie (1) selon l'une des revendications précédentes, les plusieurs dispositifs de couplage (6a à 6c) étant fixés aux moyens d'appui (7).

11. Arrangement de saisie (1) selon la revendication précédente, les plusieurs dispositifs de couplage (6a à 6c) étant reliés aux moyens d'appui (7) par complémentarité de formes, assemblage de force et/ou fusion de matières.

12. Arrangement de saisie (1) selon l'une des revendications précédentes, les moyens d'appui (7) formant une bague en matière plastique dans laquelle sont accueillis les plusieurs dispositifs de couplage (6a à 6c).

13. Arrangement de saisie (1) selon la revendication précédente, la bague formant un contour d'encliquetage (9) pour la coopération avec au moins un tenon d'encliquetage formé sur la manette (3).

14. Arrangement de saisie (1) selon l'une des revendications précédentes, le dispositif de détection capacitif (2) étant un pavé tactile ou un écran tactile.

15. Utilisation de l'arrangement de saisie (1) selon l'une des revendications précédentes dans un véhicule automobile.
